# EUROPEAN PATENT SPECIFICATION

(11) **EP 1 319 986 B1**
(45) Date of publication and mention of the grant of the patent: **27.02.2008**
(21) Application number: 02258474.2
(22) Date of filing: 09.12.2002
(51) Int. Cl.: G03F 7/20

(54) **A litographic apparatus and a device manufacturing method**
Lithographischer Projektionsapparat und Verfahren zur Herstellung einer Vorrichtung
Appareil de projection lithographique et méthode de fabrication d'un dispositif

(30) Priority: 11.12.2001 EP 01310332
(43) Date of publication of application: 18.06.2003
(73) Proprietor: ASML Netherlands B.V., 5504 DR Veldhoven (NL)
(72) Inventor: Jacobs, Hernes, 5627 CJ Eindhoven (NL); Van Der Schoot, Harmen Klaas, 5262 RK Vught (NL); Vosters, Petrus Matthijs Henricus, 5531 EH Bladel (NL); De Groot, Ton, 5712 LT Someren (NL)
(74) Representative: Leeming, John Gerard

(56) References cited:
- EP-A- 0 502 578
- US-A1- 2001 006 762
- US-B1- 6 222 614

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate; and
- a planar magnetic positioning means for positioning said substrate table in a plane; and
a mechanical limiter for limiting rotation of said substrate table about axes orthogonal to said plane.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.

- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In order accurately to position the wafer in a plane in a lithographic projection apparatus, a displacement device such as the one disclosed in WO 01/18944 may be used. The displacement device disclosed is a planar magnetic positioning means comprising a stator having a plurality of magnets in an x-y plane of an orthogonal x-y-z axis system and an electric coil system in the base of the substrate table with two types of electric coils, one type having an angular offset of +45 degrees, and the other having an offset of-45 degrees with respect to the x-direction. The magnets of the x-y plane are arranged in rows and columns according to a Halbach array, i.e. the magnetic orientation of successive magnets in each row and each column rotates 90 degrees counter-clockwise. The substrate table may be positioned by driving current through the electric coil system.

A problem has been found with planar magnetic positioning means in general and the planar magnetic positioning means disclosed in WO 01/18944 in particular, in that such systems require certain spatial relationships between the direction of polarisation of the magnets of the stator and the substrate table which, if not satisfied, results in the positioning means being unable to locate the substrate table. Furthermore, if the slider is rotated 45 degrees to the x-axis, each coil of the substrate table will be aligned with both north and south poles of the magnets of the planar magnetic positioning means and thus, any current through those coils will generate equal and opposite forces, resulting in no movement. Thus, a disadvantage of using such positioning means is that should the substrate table become misaligned by rotation about the z-axis (Rz) for such reason as a computer crash, power failure, software bug or programming error it is not possible to recover control of the substrate table automatically. Such large rotations are also deleterious to the conduits (i.e. power cords, signal carriers and gas tubes etc.) which are connected to the substrate table to supply it with utilities (e.g. power, gas, control signals etc.) because of large mechanical loads applied to those conduits.

EP-A1-0,502,578 discloses a lithographic projection apparatus with a positioning means comprising x and y linear motors arranged relative to one other in an H-shape and allow Z rotation through a limited angle.

US 2001/0006762 discloses a lithographic projection apparatus with a substrate table with planar magnetic positioning means. Z rotation of the substrate table can only be hindered by crashing into side walls of the planar magnetic positioning means.

US 6,222,614 discloses an apparatus in accordance with the precharacterizing section of claim 1.

It is an object of the present invention to provide a lithographic projection apparatus with a planar magnetic positioning means which allows automatic self recovery and minimises mechanical loads on conduits attached to the substrate table.

This and other objects are achieved according to the invention in a lithographic apparatus according to claim 1.

The mechanical limiter allows the substrate table to move freely in the x and y directions but prevents the substrate table from rotating about the z-axis beyond a certain allowed limit and can thus prevent the substrate table from rotating so far that control of the substrate table by the positioning means is no longer possible. Thus, during a crash of the substrate table, for example after computer or power failure, large loads on the conduits attached to the substrate table are substantially prevented and control of the substrate table may be recovered automatically.

The mechanical limiter may be attached at one end to said substrate table and at another end to an actuator moveable with 1 degree of freedom in the plane. This can reduce deleterious interactions between the substrate table and the mechanical limiter. Advantageously, this allows utilities to be provided through conduits to said substrate table, said conduits extending between said actuator and said substrate table. The term "conduit" as used herein refers to the "umbilical cord" which generally connects the substrate table to the outside frame (e.g. a metrology frame) which carries such items as power cords, signal carriers, gas tubes (e.g. for supplying gas to a gas bearing in the table), coolant tubes, etc.. Thus, the actuator may be used for several different purposes.

According to a further aspect of the invention there is provided a device manufacturing method according to claim 9.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation *(e.g.* with a wavelength of 365, 248, 193, 157 or 126 nm) and EUV (extreme ultra-violet radiation, *e.g.* having a wavelength in the range 5-20 nm) as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 illustrates in plan a substrate table and planar magnetic positioning means of the first embodiment of the invention;
Figure 3 illustrates in plan a substrate table and planar magnetic positioning means of a second embodiment of the present invention; and
Figures 4a and b illustrate in plan a substrate table and planar magnetic positioning means of a third embodiment.

In the Figures, corresponding reference symbols indicate corresponding parts.

### Embodiment 1

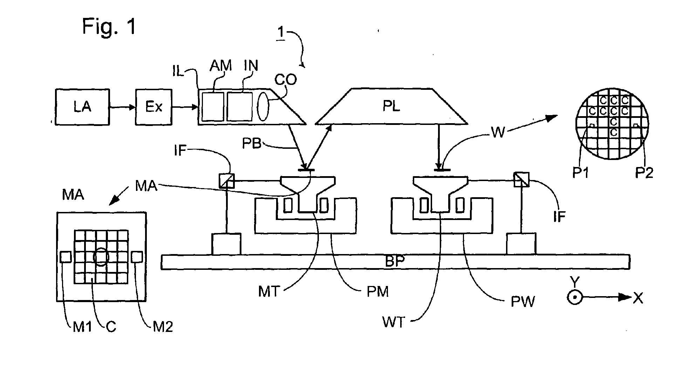

Figure 1 schematically depicts a lithographic projection apparatus according to a particular embodiment of the invention. The apparatus comprises:
a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means PM for accurately positioning the mask with respect to item PL;
a second object table (substrate table) WT provided with a substrate holder for holding a substrate W (*e.g.* a resist-coated silicon wafer), and connected to second positioning means PW for accurately positioning the substrate with respect to item PL;
a projection system ("lens") PL *(e.g.* a refractive or catadioptric system or a reflective system) for imaging an irradiated portion of the mask MA onto a target portion C (*e.g.* comprising one or more dies) of the substrate W.
As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a discharge or laser-produced plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and α-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means PW (and interferometric measuring means IF), the substrate table WT can be moved accurately, *e.g.* so as to position different target portions C in the path of the beam PB. Similarly, the first positioning means PM can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V* = *Mv*, in which *M* is the magnification of the lens PL (typically, *M* = 1/4 or 1/5). In this manner, a relatively large target portion C can be exposed, without having to compromise on resolution.

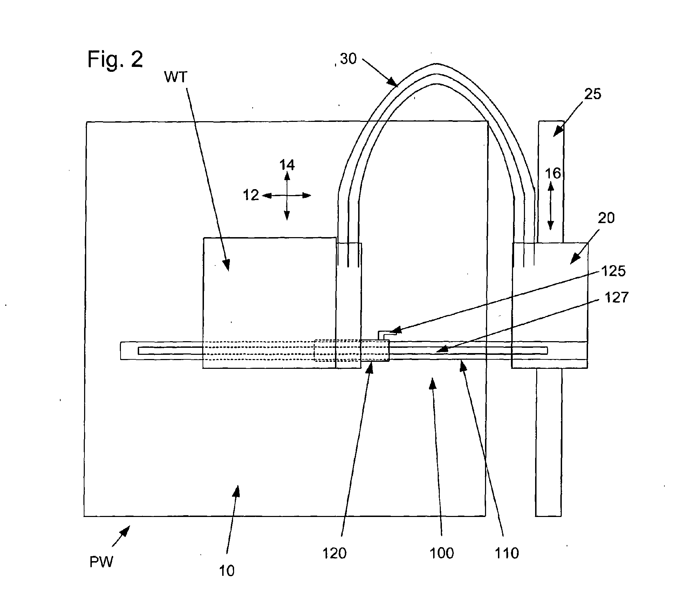

Figure 2 illustrates the substrate table WT and the second positioning means PW in more detail. The second positioning means PW is a planar magnetic positioning means having a stator 10 comprising a plurality of magnets (not illustrated) arranged in rows and columns in a single plane. The magnets in the stator 10 may be arranged according to a Halbach array, i.e. the magnetic orientation of successive magnets in each row and each column rotates 90° counter-clockwise. The substrate table WT is provided with an electric coil system in its base. The electric coil system comprises two types of coils, one type having an angular offset of + 45°, and the other having an offset of -45° with respect to the checker board configuration of the magnets. The substrate table WT may be moved relative to the stator 10 by driving current through the electric coil system in the base of the substrate table WT.

A mechanical limiter generally denoted 100 is effective to limit rotation of the substrate table WT about a direction orthogonal to the stator 10. If direction 12 is the x-axis and direction 14 the y-axis then the mechanical limiter 100 limits rotation around the z-axis (i.e. Rz).

The mechanical limiter 100 is comprised of an actuator 20 which moves in a direction 16 in the plane of the stator 10. In the illustrated embodiment the actuator moves in direction 16 which is parallel to the y-axis along a guide 25. An elongate member 110 is fixedly attached to the actuator 20. A sleeve 120 which at least partly surrounds the elongate member 110 is fixedly attached to the substrate table WT. The sleeve 120 is slidable along the elongate member 110.

In use, movement of the substrate table WT in the x-direction results in the sleeve 120 sliding along the elongate member 100. If the substrate table WT moves in the y-direction, the actuator 20 is also moved a corresponding amount in the y-direction so that the substrate table WT may move freely unhindered by the mechanical limiter 100. This is achieved by having a sensor for measuring the position of the actuator with respect to the substrate table WT and which initiates the actuator to follow the substrate table WT in the y-direction.

Preferably the substrate table WT can be moved by the positioning means PW without interference from the mechanical limiter 100. To promote this, frictionless bearings such as air bearings may be used between the sleeve 120 and the elongate member 110.

Advantageously, the mechanical limiter 100 may be provided with incremental or linear encoders 125, 127 to aid in alignment and control of the substrate table WT. Only one encoder is illustrated in Figure 2. The encoder is of an inferometer type consisting of a sensor 125 attached to the sleeve 120 and a diffraction grating 127 attached to the elongate member 110. Other types of encoder such as rotational potentiometers can be used and the position in the y-direction may also be measured. The position at which the encoders are fixed may also be different.

Should the substrate table WT experience a rotational force about the z-axis, engagement of the sleeve 120 and the elongate member 100 will substantially prevent rotation of the substrate table WT. Clearly on rotation of the substrate table WT around the z-axis each end of the sleeve 120 will come in contact on opposite sides of the elongate member 110. The amount of rotation of the substrate table WT about the z-axis allowed before rotation is stopped by the mechanical limiter 100 may be adjusted by a choice of the length of the sleeve 120 in the elongate direction of the elongate member 110 and by a choice of difference in external dimension of the elongate member 110 and the internal dimension of the sleeve 120. Alternatively, the elongate member 100 and sleeve 120 may be attached such that some limited rotation relative to the actuator 20 or substrate table WT is possible. The mechanical limiter 100 may be designed to substantially prevent any rotation or may be designed to allow for rotation of up to 3, 5 or 10 degrees. There will be included software to limit the rotation around the z-axis, however, mechanical solutions will be necessary because software may fail.

In the illustrated embodiment, conduits 30 provide the substrate table WT with utilities. Conveniently the conduit 30 may be attached between the substrate table WT and the actuator 20. In an alternative embodiment, the conduits 30 may be guided by the mechanical limiter 100 from the actuator 20 to the substrate table WT. In this way large mechanical loads on the conduits 30 can be substantially prevented as only one degree of freedom of the conduits is then required. The actuator 20 may be mounted on a track 25 and driven by suitable means such as a liner electric motor or a worm drive.

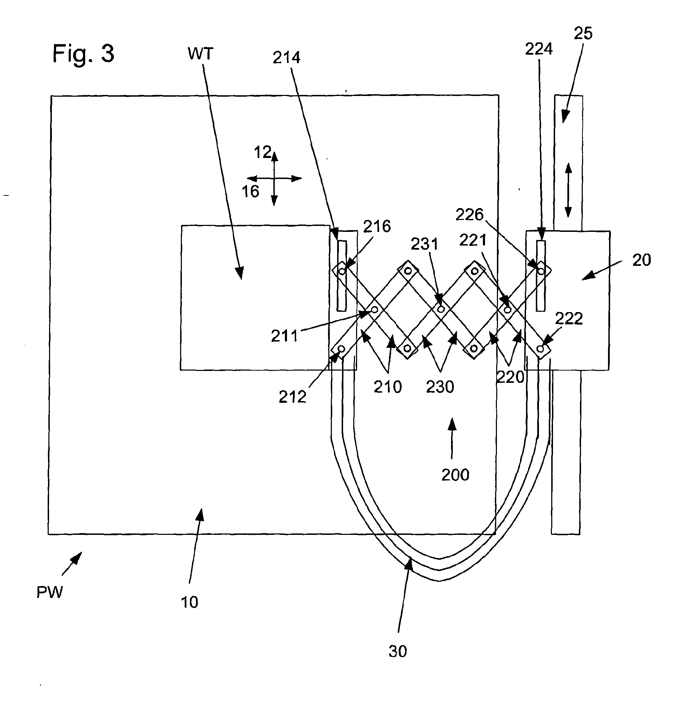

A second embodiment is illustrated in Figure 3. The second embodiment is the same as the first embodiment save as described below.

The mechanical limiter 200 of the second embodiment is the same as that of the first embodiment except that the elongate member 110 and sleeve 120 are replaced by at least one pair of crossed elongate arms 210, 220, 230. Each pair of crossed elongate arms are pivoted relative to each other at a median portion 211, 221, 231.

A first pair 210 of the at least one pair of crossed elongate arms is an outer pair of elongate arms. An outer end 212 of one arm of the outer pair of arms 210 is rotatably attached to the substrate table WT. An outer end 216 of the other elongate arm of the pair 210 is in sliding engagement with a slot 214 in the substrate table WT. In the illustrated embodiment the slot 214 is parallel to the y-axis 14.

A second pair 220 of the at least one pair of crossed elongate arms is an outer pair of elongate arms. An outer end 222 of one arm of the outer pair of arms 220 is rotatably attached to the actuator 20. An outer end 226 of the other elongate arm of the pair 220 is in sliding engagement with a slot 224 in the actuator 20. The slot 224 is parallel to the slot 214 on the substrate table WT.

Between the first pair 210 and the second pair 220 a third pair 230 of elongate arms is situated. The ends of the elongate arms of the first pair 210 and the second pair 220 not attached to the substrate table or actuator 20, are attached to ends of the elongate arms of the third pair 230.

The invention also works with only a single pair of elongate arms in which case one end of each elongate arm will be attached to the actuator 20 and the other end to the substrate table WT. Alternatively only two pairs may be used or any other number.

In use, the mechanical limiter 200 of the second embodiment is similar to that of the first embodiment for movement in the y-direction. For movement of the substrate table WT in the x-direction, the pairs of crossed elongate arms 210, 220, 230 pivot relative to each other in a scissor action to extend and retract. The ends 216, 226 engaged in slots 214 and 224 (which are parallel) allow this freedom to expand and contract and ensure that the limiter can limit rotation.

Dimensioning of the thickness of the elongate slots 214, 224 and the engagement portion of ends 216, 226 results in the desired degree of rotatability of the substrate table WT before limitation of rotation.

The second embodiment (as well as the third embodiment described below) may also have incremental or linear encoders attached to substrate table WT or the mechanical limiter 200, 300 (or the actuator in the case of the second embodiment) to measure the position of the substrate table WT and may have conduits 30 guided by the mechanical limiter 200, 300 to the substrate table WT.

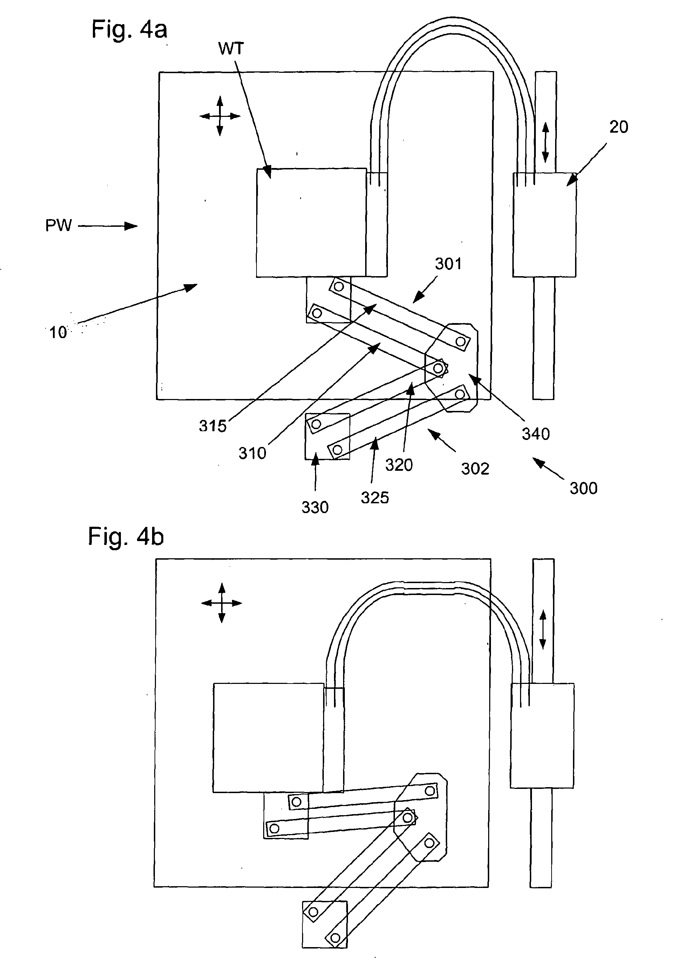

Figures 4a and b illustrate the third embodiment according to the present invention. The third embodiment is the same as the first embodiment save as described below. The mechanical limiter 300 of the third embodiment is preferred for a lithographic apparatus having only one substrate table WT. The range of movement of the single substrate table WT in such an apparatus is small compared to the range of movement required of the substrate tables WT in an apparatus with dual substrate tables WT. Thus, the mechanical limited 300 of the third embodiment is more suited to an apparatus with only a single substrate table WT.

The difference in the mechanical limiter 300 of the third embodiment to that of the first and second embodiments is that one end of the mechanical limiter 300 is fixed in a position relative to the stator 10 of the positioning means PW rather than being movable in a direction of the plane of the stator 10. The required two degrees of freedom of the end of the mechanical limiter 300 attached to the substrate table WT is achieved by use of two four-bar mechanisms generally illustrated 301 and 302. These replace the elongate member 110 and slide 120 of the first embodiment.

The first four-bar mechanism 301 is comprised of a first pair of elongate arms 310, 315 of equal length which are attached between the substrate table WT and a joining member 340. The first pair of elongate arms 310, 315 are pivotably attached at each end and the separation distance between their attachment portions on the substrate table and on the joining member 340 are equidistant such that the elongate arms 310, 315 always remain parallel.

The second four-bar mechanism 302 comprises a second pair of elongate arms 320, 325 of equal length. The second pair of elongate arms 320, 325 are attached at one end to the joining member 340 and at another end fixedly in relation to the stator 10 on a platform 330. Again, the ends of the second pair of arms 320, 325 are rotatably fixed equidistant from each other at each end.

In the illustrated embodiment the first arm 310 of the first pair of arms and the first arm 320 of the second pair of arms are pivoted about the same point on the joining member 340. This is not necessarily the case and those two arms 310, 320 may pivot at different positions on the joining member 340.

The positioning of the ends of the elongate arms and the fact that both of the first pair of arms are the same length and that both of the second pair of arms are the same length means that when the substrate table WT moves the substrate table WT will be constrained in its rotation about the z axis by the mechanical limiter 300. If a wider range of rotation is required, the platform 330 may be attached to an actuator (i.e. actuator 20) such that a larger range of motion of the substrate table WT is possible.

Whilst specific embodiments of the invention have been described above, it would be appreciated that the invention may be practiced otherwise than as described. The description is not intended to limit the invention which is defined by the claims.

## Claims

1. A lithographic projection apparatus comprising:
- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a planar magnetic positioning means arranged to position said substrate table in a plane said planar magnetic positioning means comprising a stator (10) and an electric coil system; and
a mechanical limiter for limiting rotation of said stator relative to said electric coil system whereby the rotation of said substrate table about axes orthogonal to said plane is limited irrespective of the position of said substrate table,
**characterized in that** said mechanical limiter is arranged to prevent said substrate table from rotating around said axes beyond 10°.

2. A lithographic projection apparatus according to claim 1, wherein said mechanical limiter allows said substrate table to rotate up to 5°, preferably 3° around said axes before limiting rotation of said substrate table about said direction.

3. A lithographic projection apparatus according to claim 1 or 2, wherein said substrate table is positionable by said planar magnetic positioning means in said plane substantially without interference from said mechanical limiter.

4. A lithographic projection apparatus according to any one of the preceding claims, wherein said mechanical limiter engages with said substrate table at at least two positions.

5. A lithographic projection apparatus according to any one of the preceding claims, wherein said mechanical limiter allows said substrate table substantially the same amount of rotation around said axes irrespective of the position of said substrate table.

6. A lithographic projection apparatus according to any one of the preceding claims, wherein said mechanical limiter is attached at one end to said substrate table and at another end to an actuator moveable with 1 degree of freedom in said plane relative to said planar magnetic positioning means.

7. A lithographic projection apparatus according to claim 6, wherein said mechanical limiter comprises an elongate member and a sleeve slidable along said elongate member in the elongate direction and partly surrounding said elongate member, one of said elongate member and sleeve attached to said actuator and another of said elongate member and sleeve attached to said substrate table.

8. A lithographic projection apparatus according to claim 6, wherein said mechanical limiter comprises at least one pair of crossed elongate arms pivoted relative to each other at a median portion of each of said crossed elongate arms.

9. A device manufacturing method using the apparatus of claim 1 comprising the steps of:
- providing a substrate that is at least partially covered by a layer of radiation-sensitive material;
- holding said substrate on the substrate table;
- positioning said substrate table in a plane using the planar magnetic positioning means;
- providing a projection beam of radiation using the radiation system;
- using patterning means to endow the projection beam with a pattern in its cross-section;
- projecting the patterned beam of radiation onto a target portion of the layer of radiation-sensitive material;
- limiting rotation of said substrate table beyond 10° about axes orthogonal to said plane using the mechanical limiter.

## Patentansprüche

1. Ein lithographischer Projektionsapparat, aufweisend:
ein Strahlungssystem zur Bereitstellung eines Projektionsstrahls einer Strahlung;
eine Tragstruktur zum Tragen von Musterungsmitteln, wobei die Musterungsmittel dazu dienen, den Projektionsstrahl gemäß einem gewünschten Muster zu mustern;
einen Substrattisch zum Halten eines Substrats;
ein Projektionssystem zum Projizieren des gemusterten Strahls auf einen Zielabschnitts des Substrats;
ebene magnetische Positioniermittel, welche den Substrattisch in einer Ebene zu positionieren vermögen, wobei die ebenen magnetischen Positioniermittel einen Stator (10) und ein elektrisches Spulensystem aufweisen; und
einen mechanischen Begrenzer zur Begrenzung einer Drehung des Stators relativ zu dem elektrischen Spulensystem, wodurch die Drehung des Substrattisches um Achsen senkrecht zu der Ebene ungeachtet der Position des Substrattisches begrenzt wird,
**dadurch gekennzeichnet, dass** der mechanische Begrenzer zu verhindern vermag, dass der Substrattisch um mehr als 10° drehen kann.

2. Ein lithographischer Projektionsapparat nach Anspruch 1, bei dem der mechanische Begrenzer erlaubt, dass der Substrattisch bis zu 5°, bevorzugt 3° um die Achsen drehen kann, bevor eine Drehung des Substrattisches in diese Richtung begrenzt wird.

3. Ein lithographischer Projektionsapparat nach Anspruch 1 oder 2, bei dem der Substrattisch durch die ebenen magnetischen Positioniermittel in der Ebene im Wesentlichen ohne Störung durch die mechanischen Begrenzer positionierbar ist.

4. Ein lithographischer Projektionsapparat nach einem der vorhergehenden Ansprüche, wobei der mechanische Begrenzer mit dem Substrattisch an wenigstens zwei Positionen in Anlage gerät.

5. Ein lithographischer Projektionsapparat nach einem der vorhergehenden Ansprüche, wobei der mechanische Begrenzer dem Substrattisch ungeachtet der Position des Substrattisches im Wesentlichen den gleichen Drehbetrag um die Achsen erlaubt.

6. Ein lithographischer Projektionsapparat nach einem der vorhergehenden Ansprüche, wobei der mechanische Begrenzer an einem Ende an dem Substrattisch angebracht ist und am anderen Ende am Stellglied, welches mit einem Freiheitsgrad in der Ebene relativ zu den ebenen magnetischen Positioniermitteln bewegbar ist.

7. Ein lithographischer Projektionsapparat nach Anspruch 6, bei dem der mechanische Begrenzer ein langgestrecktes Bauteil und eine Hülse aufweist, die entlang des langgestreckten Bauteils in Längsrichtung gleitbar ist und teilweise das langgestreckte Bauteil umfasst, wobei eines von langgestrecktem Bauteil und Hülse an dem Stellglied angebracht ist und das andere von langgestrecktem Bauteil und Hülse an dem Substrattisch angebracht ist.

8. Ein lithographischer Projektionsapparat nach Anspruch 6, bei dem der mechanische Begrenzer wenigstens ein Paar von überkreuzten langgestreckten Armen aufweist, die relativ zueinander in einem mittigen Abschnitt eines jeden der überkreuzten langgestreckten Arme schwenkbeweglich sind.

9. Ein Vorrichtungsherstellungsverfahren unter Verwendung des Apparates von Anspruch 1, aufweisend die Schritte von
Bereitstellen eines Substrats, welches zumindest teilweise mit einer Schicht aus strahlungsempfindlichen Material bedeckt ist;
Halten des Substrates auf dem Substrattisch;
Positionieren des Substrattisches in einer Ebene unter Verwendung der ebenen magnetischen Positioniermittel;
Bereitstellen eines Projektionsstrahls von Strahlung unter Verwendung des Strahlungssystems;
Verwenden von Musterungsmitteln, um den Projektionsstrahl in seinem Querschnitt mit einem Muster zu versehen;
Projizieren des gemusterten Strahls der Strahlung auf einen Zielabschnitt der Schicht aus strahlungsempfindlichem Material;
Begrenzen einer Drehung des Substrattisches über 10° hinaus um Achsen senkrecht zu der Ebene unter Verwendung des mechanischen Begrenzers.

## Revendications

1. Appareil de projection lithographique, comprenant :
un système de rayonnement pour fournir un faisceau de rayonnement de projection ;
une structure de support pour supporter des moyens de mise en forme, les moyens de mise en forme servant à mettre en forme le faisceau de rayonnement suivant un motif souhaité ;
une table de substrat pour maintenir un substrat ;
un système de projection pour projeter le faisceau mis en forme sur une partie cible du substrat ;
des moyens magnétiques de positionnement planaire agencés de manière à positionner ladite table de substrat dans un plan, lesdits moyens magnétiques de positionnement planaire comprenant un stator (10) et un système de bobine électrique ; et
un limiteur mécanique pour limiter la rotation dudit stator par rapport audit système de bobine électrique, moyennant quoi la rotation de ladite table de substrat autour d'axes orthogonaux audit plan est limitée indépendamment de la position de ladite table de substrat,
**caractérisé en ce que** ledit limiteur mécanique est agencé de manière à empêcher ladite table de substrat de tourner autour desdits axes au-delà de 10°.

2. Appareil de projection lithographique selon la revendication 1, dans lequel ledit limiteur mécanique permet à ladite table de substrat de tourner jusqu'à 5°, de préférence 3°, autour desdits axes avant de limiter la rotation de ladite table de substrat autour de ladite direction.

3. Appareil de projection lithographique selon la revendication 1 ou 2, dans lequel ladite table de substrat peut être positionnée par lesdits moyens magnétiques de positionnement planaire dans ledit plan sensiblement sans interférence dudit limiteur mécanique.

4. Appareil de projection lithographique selon l'une quelconque des revendications précédentes, dans lequel ledit limiteur mécanique vient en prise avec ladite table de substrat en au moins deux positions.

5. Appareil de projection lithographique selon l'une quelconque des revendications précédentes, dans lequel ledit limiteur mécanique permet à ladite table de substrat sensiblement la même valeur de rotation autour desdits axes, indépendamment de la position de ladite table de substrat.

6. Appareil de projection lithographique selon l'une quelconque des revendications précédentes, dans lequel ledit limiteur mécanique est fixé à une extrémité à ladite table de substrat et à une autre extrémité à un actionneur pouvant se déplacer avec 1 degré de liberté dans ledit plan par rapport aux dits moyens magnétiques de positionnement planaire.

7. Appareil de projection lithographique selon la revendication 6, dans lequel ledit limiteur mécanique comprend un élément allongé et un manchon pouvant coulisser le long dudit élément allongé dans la direction de la longueur et entourant partiellement ledit élément allongé, l'un dudit élément allongé et dudit manchon étant fixé audit actionneur et l'autre dudit élément allongé et dudit manchon étant fixé à ladite table de substrat.

8. Appareil de projection lithographique selon la revendication 6, dans lequel ledit limiteur mécanique comprend au moins une paire de bras allongés croisés en pivotement mutuel à une partie médiane de chacun desdits bras allongés croisés.

9. Procédé de fabrication d'un dispositif utilisant l'appareil selon la revendication 1, comprenant les étapes consistant à :
fournir un substrat qui est au moins partiellement recouvert par une couche de matériau sensible au rayonnement ;
maintenir ledit substrat sur la table de substrat;
positionner ladite table de substrat dans un plan en utilisant les moyens magnétiques de positionnement planaire ;
fournir un faisceau de rayonnement de projection en utilisant le système de rayonnement ;
utiliser des moyens de mise en forme pour doter le faisceau de projection d'un motif dans sa section transversale ;
projeter le faisceau de rayonnement mis en forme sur une partie cible de la couche de matériau sensible au rayonnement ;
limiter la rotation de ladite table de substrat au-delà de 10° autour d'axes orthogonaux audit plan en utilisant le limiteur mécanique.
